# EUROPEAN PATENT APPLICATION

(11) **EP 1 267 493 A2**
(43) Date of publication of application: **18.12.2002**
(21) Application number: 02006111.5
(22) Date of filing: 18.03.2002
(51) Int. Cl.: H03K 23/54

(54) **Odd-number factor frequency divider and 90 degrees phase splitter which operates from output signal of the frequency divider**

(30) Priority: 18.05.2001 JP 2001149584
(71) Applicant: MATSUSHITA ELECTRIC INDUSTRIAL CO., LTD., Kadoma-shi, Osaka 571-8501 (JP)
(72) Inventor: Hirano, Shunsuke, Yokohama 245-0061 (JP)
(74) Representative: Manitz, Finsterwald & Partner GbR

(57) **Abstract**

An odd number factor frequency divider which generates a final output signal having a duty ratio of 1/2 is formed of a plurality of cascade-connected MSD-FFs (master-slave D-type flip-flops), operating from a common clock signal, with a single NOR gate (3) being used to derive a signal expressing the negated logic sum of the respective Q-terminal logic outputs from the master D-type latch and the slave D-type latch which constitute the final-stage MSD-FF (MSD-FF(n-1)) of the plurality of cascade-connected MSD-FFs, with that output signal from the NOR gate being applied to the D input terminal of the first-stage MSD-FF, (MSD-FF1) while also being supplied to an output terminal (1) as the final output signal from the frequency divider. Since a minimum number of circuit elements are employed, the overall circuit scale can be small, and current consumption low.

## Description

### BACKGROUND OF THE INVENTION

### Field of Application

The invention relates to a frequency divider which operates with a division factor that is an odd number, and in particular to an odd number factor frequency divider that produces a frequency-divided output signal having a duty ratio of 1/2, and to a 90° phase splitter which operates from the output signal produced by such a frequency divider.

### Description of Prior Art

Types of odd number factor frequency divider are known in the prior art, whereby a plurality of master-slave D-type flip-flops (referred to in the following as MSD-FFs) are connected in cascade, operating from a common clock signal, with a final output signal being generated at a frequency which is equal to the clock signal frequency divided by an odd number.

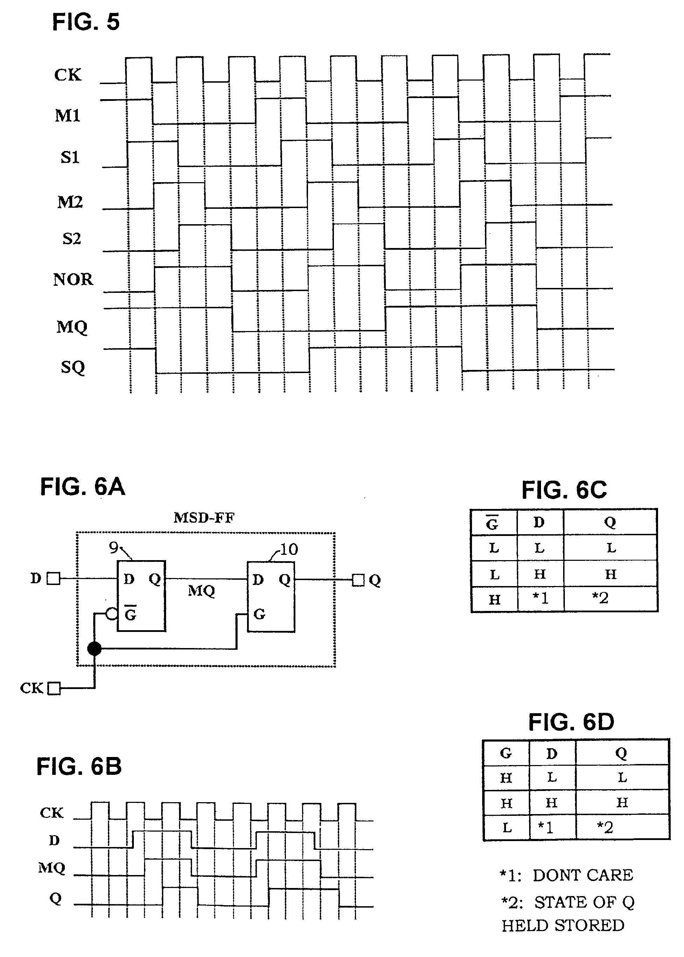

A simple explanation of MSD-FF operation will first be given. Fig. 6A shows a master D-type latch 9 and a slave D-type latch 10 which are connected in cascade to constitute a MSD-FF, while Figs. 6B is a timing chart of the operation of the MSD-FF, and Figs. 6C, 6D are respective truth tables for the master D-type latch 9 and slave D-type latch 10. As shown in the truth table of Fig. 6C, when the /G terminal of the master D-type latch 9 is at the L level, the input signal to the D terminal appears as the Q-terminal output, i.e., as signal MQ. While the /G terminal of the master D-type latch is at the H level, the Q-terminal output is held unchanged. (The logic negation symbol is indicated in this text by the / symbol). In the case of a slave D-type latch as shown in the truth table of Fig. 6D, when the G terminal is at the H level, the signal level applied to the D input terminal appears at the Q output terminal, while when the G terminal is at the L level the Q-terminal output level is held unchanged. As a result, in the case of a MSD-FF formed of a master D-type latch and slave D-type latch connected in cascade, when a rising edge of the clock signal (CK) occurs, the input signal level which is being applied to the D input terminal of the flip-flop appears at the Q output terminal of the flip-flop, while when the succeeding rising edge of the clock signal occurs, the Q output terminal level is held unchanged.

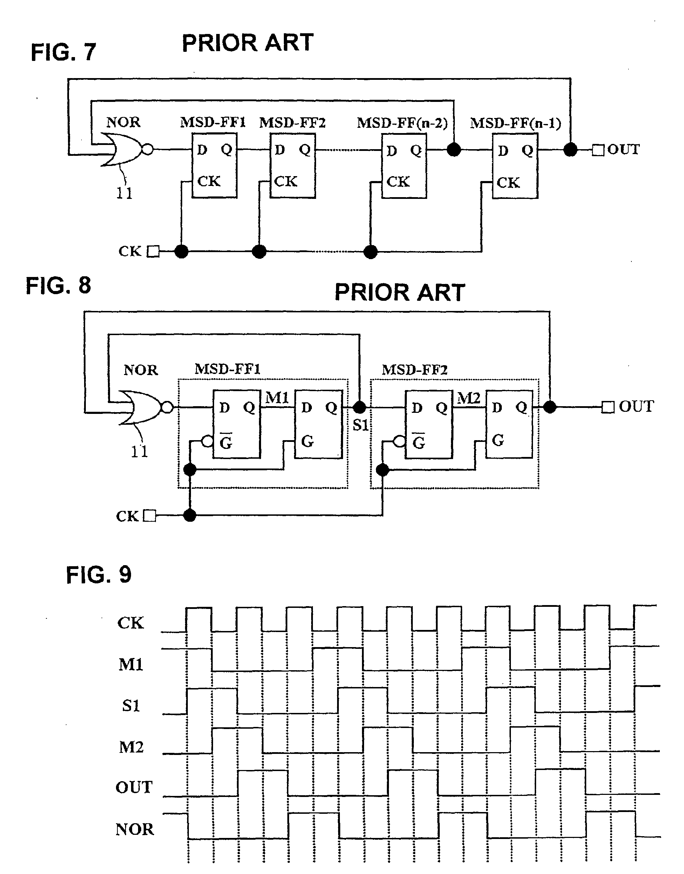

Fig. 7 shows the configuration of a prior art type of odd number factor frequency divider, having a division factor of (2n + 1), where n is a natural number. As shown, (n - 1) stages of MSD-FFs are connected in cascade, with the same clock signal being applied to each stage. The negated logic sum of the D terminal input signal and Q terminal output signal of the final-stage MSD-FF is obtained as the output signal from a NOR gate 11, which is applied as the input signal to the D terminal of the initial-stage MSD-FF. The Q-terminal output from the final-stage MSD-FF constitutes the final output signal from the frequency divider.

In the following, a frequency divider circuit which produces an output signal having a frequency that is 1/N times that of a signal supplied thereto as a clock signal, where N is a natural number, will be referred to as a "factor N frequency divider".

The operation of this prior art odd number factor frequency divider will be described in the following. For simplicity of description it will be assumed that n is equal to 1, i.e. that frequency division by 1/3 is performed. The circuit configuration in that case is as shown in Fig. 8, having two stages, MSD-FF1 and MSD-FF2, together with a NOR gate which derives the negated logic sum of the Q-terminal output signals from these flip-flops. For ease of comparison with a circuit configuration that is described hereinafter, each MSD-FF is shown as formed of a master D-type latch and a slave D-type latch.

The operation will be described using the timing chart of Fig. 9. It is assumed that initially the Q output terminal of each MSD-FF is at the L level, so that the output signal from the NOR gate is at the H level. In that condition, when the clock signal CK then goes from the H to the L level, the output signal M1 from the first stage of the MSD-FF1 goes the H level. When the clock signal CK then goes from the L to the H level, the output signal S1 from the second stage of the MSD-FF1 goes to the H level, so that the output from the NOR gate goes to the L level. At that time, the master D-type latch of MSD-FF1 is in the condition whereby the state of the Q output terminal is held stored, and so the signal M1 remains at the H level. Next, when clock signal CK returns to the L level, the H level condition of signal S1 is maintained and signal M2 (the output from the first stage of MSD-FF2) goes to the H level. When the clock signal CK next goes to the H level, signal S1 goes to the L level, and the output signal OUT (produced from the second stage of MSD-FF2) goes to the H level. The next time that the clock signal CK goes to the L level, the initial state described above is returned to. The above series of operations is thereafter repetitively performed. The duty ratio of the output signal OUT is 1/3. In the case of the 1/(2n + 1) frequency divider of Fig. 7, the duty ratio of the output signal OUT is n/(2n + 1).

In some cases, the local oscillator signal that is used for modulation and demodulation in a mobile radio apparatus is derived by frequency division of a signal produced from a source such as a frequency synthesizer. When quadrature modulation and quadrature demodulation are performed, then instead of a single local oscillator signal, it is necessary to use a pair of signals which differ in phase by 90 degrees. In the following, for simplicity of description, a high-frequency signal which is operated on by frequency dividing and phase shifting to obtain such a pair of signals for use in quadrature modulation and demodulation in a radio apparatus will be referred to as the local oscillator signal.

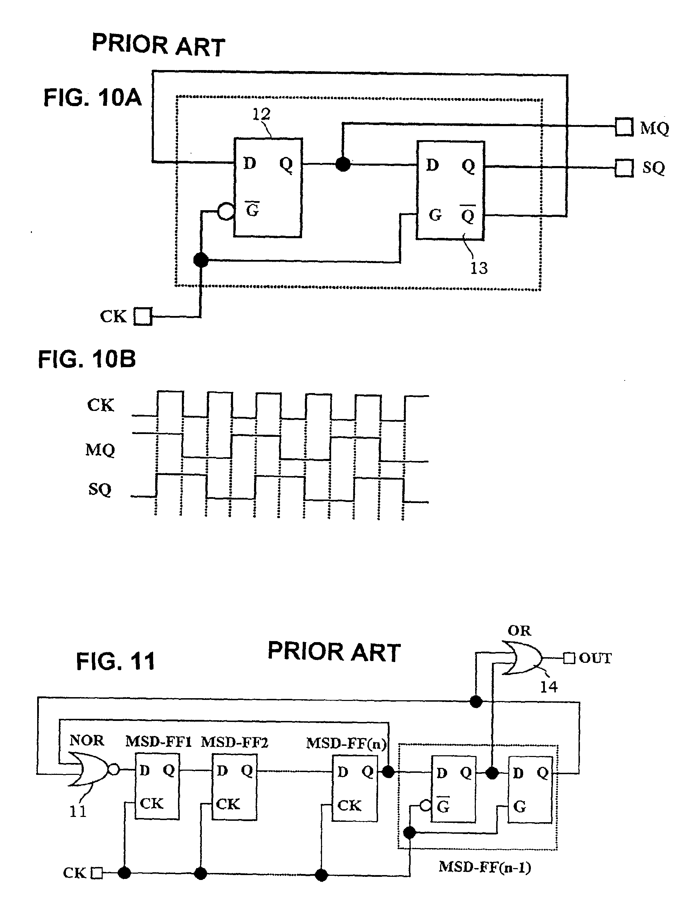

Fig. 10A shows an example of a factor 2 frequency divider formed of a master D-type latch 12 and slave D-type latch 13, used as a phase splitter circuit for generating such a pair of signals which differ in phase by 90°, while Fig. 10B is a timing chart of the operation of the circuit of Fig. 10A. The output signals which differ in phase by 90° are designated as MQ, SQ respectively. As can be understood from the timing chart, it is essential that the duty ratio of the input signal CK (i.e., the local oscillator signal, in the case of a mobile radio apparatus application as described above) be 1/2, to ensure that the signals MQ, SQ will correctly differ in phase by 90°.

For example it will be assumed that the frequency of the local oscillator signal is 6 times that of the modulation frequency so that the local oscillator signal frequency should be divided by 3, to obtain a suitable frequency of clock signal to be applied to the phase splitter circuit of Fig. 10A. With the prior art type of factor 3 frequency divider, the duty ratio of the output signal is 1/3, so that if that output signal were to be used in a 90° phase splitter circuit of the form shown in Fig. 10A, it would not be possible to obtain a pair of output signals which correctly differ in phase by 90° .

Furthermore, if the frequency of the local oscillator signal were 2 x (2n + 1) times that of the modulation frequency, and if a prior art type of factor 1/(2n + 1) frequency divider were to be used, the resultant output signal would have a duty ratio of n/(2n + 1), so that if such a signal were supplied to a factor 2 frequency divider circuit functioning as a phase splitter circuit, it would not be possible to obtain a pair of output signals which correctly differ in phase by 90°.

Thus as can be understood from the above, since with a prior art type of odd number factor frequency divider the duty ratio of the output signal produced is not 1/2, it is not possible to use such an output signal directly in a factor 2 frequency divider type of phase splitter circuit. If it required to use such an output signal, it is necessary to apply some means of compensating the duty ratio of the signal, or some means of applying phase compensation to the output signals produced from the phase splitter circuit. If this is done, then since in general the frequencies used to perform modulation and demodulation in a mobile radio apparatus are in the range of several hundred megahertz, the power consumption of the apparatus will be excessively increased. Furthermore the circuit scale will become large, and problems of manufacturing cost will arise when the circuit is implemented as an IC (integrated circuit).

To avoid the above problems, a proposal has been made in Japanese patent No. HEI 6-216761 whereby an odd number factor frequency divider is provided which generates an output signal having a duty ratio of 1/2. Fig. 11 shows the configuration of this prior art circuit. As shown, this differs from the prior art circuit of Fig. 7 in that an additional OR gate 14 is incorporated, for deriving the logic sum of the Q-terminal output signal from the master D-type latch of the final stage MSD-FF(n - 1) and the Q-terminal output signal of the slave D-type latch of that MSD-FF. The output signal from that NOR gate 14 constitutes the final output signal from the odd number factor frequency divider.

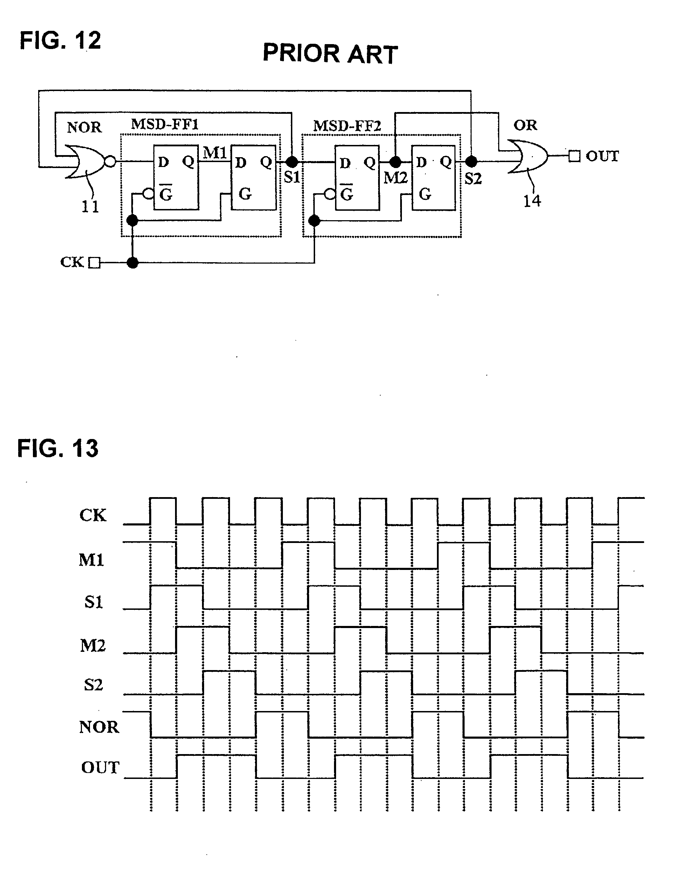

The operation of this modified odd number factor frequency divider will be described for the case of n being equal to 1, i.e., a factor 3 frequency divider, so that the configuration is as shown in Fig. 12. Here, the OR gate obtains the logic sum of the Q-terminal output signal M2 from the master D-type latch of MSD-FF2 and the Q-terminal output signal S2 from the slave D-type latch of MSD-FF2, with the output signal produced from the OR gate 14 constituting the final output signal from the frequency divider. It can be understood that the additional OR gate 14 is the only feature of difference from the prior art frequency divider circuit of Fig. 8.

The operation will be described referring to the timing chart of Fig. 13. Assuming that each of the Q-terminal output signals from respective MSD-FFs is at the L level, the output from the NOR gate will be at the H level. When the input clock signal CK then goes from the H to the L level, the output signal M1 from the first stage of MSD-FF1 goes to the H level, while when signal CK then goes to the H level, the output signal S1 from the second stage of MSD-FF1 goes to the H level. As a result, the output of the NOR gate goes to the L level. In this condition, the master D-type latch of MSD-FF1 is in the mode whereby the level of its Q-terminal output is held unchanged when the clock signal L to H transition occurs, so that signal M1 remains at the H level. At the next transition of signal CK from the H to L level, the signal S1 remains at the H level, and signal M2 goes to the H level. When signal CK then returns to the H level, signal S2 goes to the H level. The next time that signal CK goes to the H level, the initial condition is restored, and the operation thereafter is a repetition of that described above. Since the OR gate derives the logic sum of signals which differ in phase by 1/2 of a period of the input clock signal CK, the duty ratio of the output signal OUT is 1/2. Similarly, in the case of the factor (2n +1) frequency divider of Fig. 11, the duty ratio of the output signal is also 1/2.

However with the above type of prior art odd number factor frequency divider which produces an output signal having a duty ratio of 1/2, since the number of logic gates is large, the problems will arise of an excessive level of current consumption, increased circuit scale and increased manufacturing costs, if such a circuit is used to operate on the local oscillator signal of a mobile radio apparatus, i.e., is used to supply an input signal to a phase splitter circuit to obtain output signals for use in quadrature modulation and demodulation as described above. Furthermore due to the increased power consumption of a mobile radio apparatus which uses such a frequency divider, problems will arise with regard to shortening of the time for which the apparatus can be used in a conversation mode, or in a waiting mode.

### SUMMARY OF THE INVENTION

It is an objective of the present invention to overcome the problems of the prior art set out above, by providing an odd number factor frequency divider which produces an output signal having a duty ratio of 1/2, whereby the circuit scale of the frequency divider can be small, and current consumption can be low.

To achieve the above objective, the invention provides an odd number factor frequency divider formed of a plurality of MSD-FFs connected in cascade and operating from the same clock signal, with each MSD-FF being formed of a master D-type latch and a slave D-type latch connected in cascade, with the master D-type latch being synchronized with the clock signal and the slave D-type latch being synchronized with the inverse of the clock signal. The divider further includes a NOR gate for producing an output signal expressing the negated logic sum of a Q-terminal output from a master D-type latch of a final stage of the cascade-connected plurality of MSD-FFs and a Q-terminal output from a slave D-type latch of that final MFD-FF stage, with the NOR gate output signal being applied to a D input terminal of a master D-type latch of a MSD-FF of an initial stage of the cascade-connected plurality of MSD-FFs. The output signal produced from the NOR gate constitutes the final output signal of the frequency divider. Such a circuit can constitute an odd number factor frequency divider which can be small in circuit scale and have low current consumption, while providing an output signal having a duty ratio of 1/2.

### BRIEF DESCRIPTION OF THE DRAWINGS

Fig. 1 is a circuit diagram of a first embodiment, which is an odd number factor frequency divider;
Fig. 2 is a circuit diagram of the first embodiment implemented as a factor 3 frequency divider;
Fig. 3 is a timing chart of the operation of the factor 3 frequency divider of Fig. 2;
Fig. 4 is a circuit diagram of a second embodiment, which is a phase splitter circuit operating from a frequency-divided local oscillator signal, produced from the frequency divider of Fig. 2;
Fig. 5 is a timing chart for describing the operation of the circuit of Fig. 4;
Fig. 6A is a circuit diagram of the configuration of a MSD-FF, while Fig. 6B is a corresponding timing chart and Figs. 6C, 6D are respective truth tables for a master D-type latch and a slave D-type latch which constitute the MSD-FF of Fig. 6A;
Fig. 7 is a circuit diagram of a prior art example of a (2n +1) factor frequency divider;
Fig. 8 is a circuit diagram of the frequency divider of Fig. 7 implemented as a factor 3 frequency divider;
Fig. 9 is a timing chart showing the operation of the prior art factor 3 frequency divider of Fig. 8;
Fig. 10A is a circuit diagram of a phase splitter circuit constituted as a factor 2 frequency divider, and Fig. 10B is a corresponding timing chart;
Fig. 11 is a circuit diagram of a prior art example of a factor (2n +1) frequency divider which produces an output signal having a duty ratio of 1/2;
Fig. 12 is a circuit diagram of the frequency divider of Fig. 11 implemented as a factor 3 frequency divider; and
Fig. 13 is a timing chart showing the operation of the prior art factor 3 frequency divider of Fig. 12.

### DESCRIPTION OF PREFERRED EMBODIMENTS

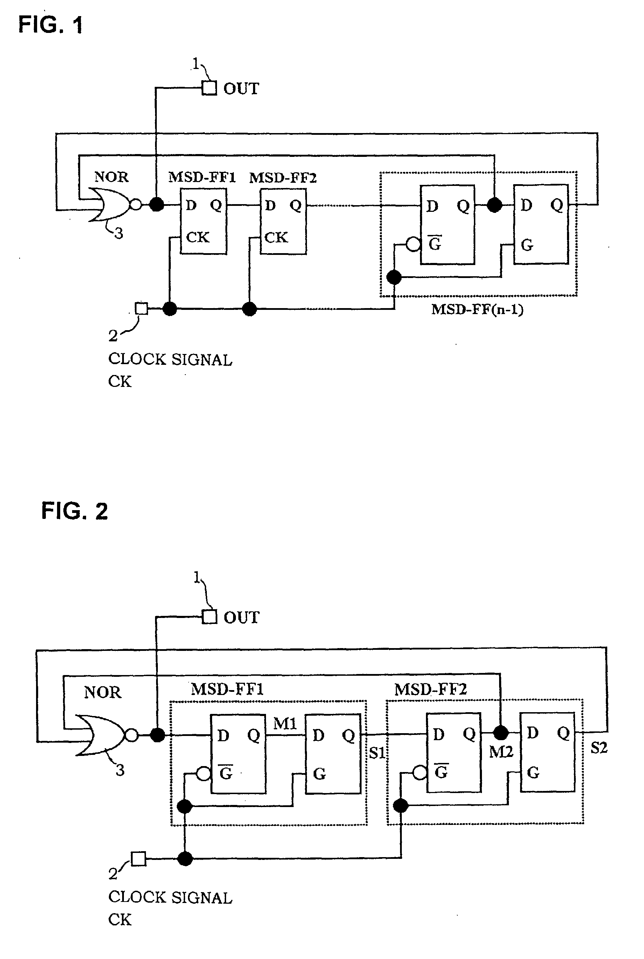

Embodiments of the invention will be described in the following, referring to Figs. 1 to 5.

### First Embodiment

The first embodiment is an odd number factor frequency divider whereby an output signal is generated expressing the NOR function (i.e., negated logic sum) of respective Q-terminal output signals of a master D-type latch and slave D-type latch of a final stage MSD-FF of a series of cascade-connected MSD-FFs, with that output signal being applied to the D input terminal of a first-stage MSD-FF, while also constituting the final output signal from the frequency divider.

Fig. 1 is a block diagram showing the circuit configuration of this first embodiment, which is a factor (2n + 1) frequency divider. In Fig. 1, MSD-FF1 and MSD-FF(n - 1) are respectively the first stage and final stage of a cascade-connected plurality of MSD-FFs. The circuit performs frequency division of a clock signal CK which is supplied from an external source to an input terminal 2, to obtain a final output signal OUT on an output terminal 1. Numeral 3 denotes a NOR gate. Two basic features of difference between this odd number factor frequency divider and the prior art odd number factor frequency divider of Fig. 7 are that:
(a) with this embodiment, a signal expressing the NOR function of the Q-terminal output signal from the master D-type latch of the final-stage MSD-FF and the Q-terminal output from the slave D-type latch of that final-stage MSD-FF is derived by the NOR gate 3, and applied to the D input terminal of the first-stage one of the plurality of cascade-connected MSD-FFs (i.e., to the D input terminal of the master D-type latch of that first-stage MSD-FF), and
(b) the output signal from the NOR gate 3 is supplied to an output terminal 1, to constitute the final output signal OUT from the frequency divider.

Fig. 2 shows the configuration of the first embodiment when implemented as a factor 3 frequency divider. This differs from the prior art factor 3 frequency divider of Fig. 8 in that a signal expressing the NOR function of the Q-terminal output signal from the master D-type latch of the second-stage MSD-FF2 and the Q-terminal output from the slave D-type latch of that MSD-FF2 is derived by the NOR gate 3, and in that the output signal from that NOR gate 3 constitutes the final output signal from the factor 3 frequency divider.

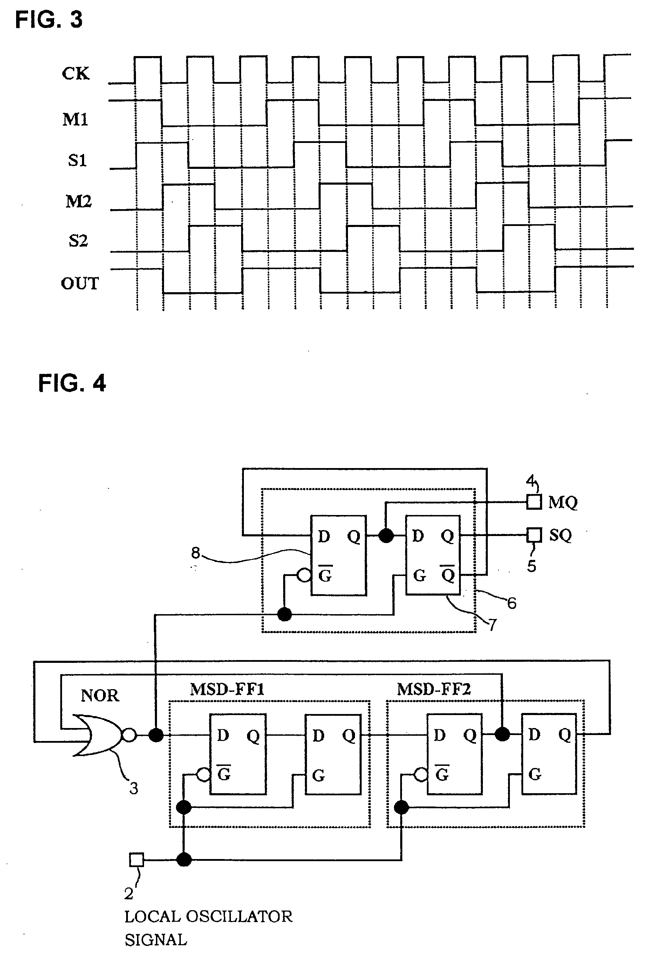

Fig. 3 is a timing chart for describing the operation of this factor 3 frequency divider.

Referring to Fig. 3, the operation is as follows, with the signal designations M1, M2, S1 respectively having the same significances as for the prior art example of Fig. 8 described above, and S2 denoting the Q output signal from the slave D-type latch of MSD-FF2. Firstly, assuming that the respective Q-terminal outputs in both of the MSD-FFs are initially all at the L level, then in that condition the output from the NOR gate 3, constituting the final output signal OUT, is at the H level. Signal M1 then goes to the H level at the first transition of the clock signal CK from the H to the L level, and signal 31 then goes to the H level at the succeeding transition of signal CK from the L to the H level. When signal CK then goes to the L level, signal S1 remains at the H level, and signal M2 goes to the H level. As a result, the output signal OUT goes to the L level. When signal CK then goes to the H level, signal S1 goes to the L level while at the same time the signal S2 goes to the H level. When signal CK then goes to the L level and then to the H level, the initial condition described above has been returned to, with signal OUT at the H level. The above sequence of operations is thereafter repetitively executed. As can be understood from Fig. 3, the duty ratio of the output signal OUT is 1/2.

In a similar manner, in the case of the factor (2n + 1) frequency divider of Fig. 1, the duty ratio of the output signal OUT is 1/2.

Thus with the first embodiment as described above, a signal is derived expressing the negated logic sum of the Q-terminal output signal from the master D-type latch of the final-stage MSD-FF and the Q-terminal output signal from the slave D-type latch of that final-stage MSD-FF, and that derived signal is applied to the D input terminal of the first-stage MSD-FF. In addition, that derived signal constitutes the final output signal from the frequency divider. Hence since only a single logic gate need be incorporated in addition to the MSD-FFs, the circuit scale can be small and the overall current consumption of the frequency divider can be low. Thus when such a odd number factor frequency divider is used for example to operate on the local oscillator signal used for modulation and demodulation in a mobile radio apparatus, increased battery life can be achieved for the apparatus, i.e., the durations for which the apparatus can be used to carry out telephone conversations or can be left in a call waiting condition can be increased.

### Second Embodiment

With a second embodiment of the invention, the output signal from the odd number factor frequency divider is applied as a clock signal to a 90° phase splitter circuit which is implemented as a single MSD-FF, with the inverted Q output from the slave D-type latch applied to the D input terminal of the master D-type latch, as described above referring to Fig. 10A. The respective Q-terminal output signals from a master D-type latch and a slave D-type latch of that MSD-FF constitute the two final output signals from the phase splitter circuit.

Fig. 4 shows the configuration of the second embodiment, which is assumed for simplicity of description to use a factor 3 frequency divider in accordance with the first embodiment of the invention. It is assumed that the circuit is for use in a radio apparatus such as a mobile radio apparatus, and that the clock signal which is supplied to the factor 3 frequency divider is a local oscillator signal, i.e., a signal whose frequency is three times that which is required for each of two quadrature modulation/demodulation signals which differ in phase by 90°. As shown, the resultant output signal from the factor 3 frequency divider is supplied to a phase splitter circuit that is constituted by a MSD-FF 6 formed of a master D-type latch 8 and slave D-type latch 7, with the inverted (/Q) output from the slave D-type latch 7 being supplied to the D input terminal of the master D-type latch 8, and with the output signals MQ, SQ from the Q terminals of the master D-type latch 8 and slave D-type latch 7 being respectively supplied to output terminals 4, 5 as the required pair of signals which differ in phase by 90°.

Fig. 5 is a timing chart of the operation of the circuit of Fig. 4. It can be understood from Fig. 5 that, since the duty ratio of the clock signal (i.e., output signal from NOR gate 3) that is supplied to the 90° phase splitter circuit is 1/2, the two output signals from the 90° phase splitter circuit correctly differ in phase from one another by 90°. Hence it is not necessary to use additional circuit components to correct the duty ratio of the clock signal supplied to the phase splitter circuit, or to apply phase correction to the output signals from the phase splitter circuit. The circuit scale can therefore be small, and the current consumption can be low. Hence, a mobile radio apparatus which utilizes such a circuit to derive quadrature modulation and demodulation signals can have an extended duration of use before battery replacement becomes necessary.

Although the above description has been given for the case of a factor 3 frequency divider being used, the same results can be obtained in general for a factor (2n + 1) frequency divider being used to operate on the local oscillator signal, where n is a natural number.

## Claims

1. An odd number factor frequency divider comprising
a plurality of master-slave D-type flip-flops connected in cascade and operating from the same clock signal, each master-slave D-type flip-flop formed of a master D-type latch and a slave D-type latch connected in cascade, with the master D-type latch synchronized with the clock signal and the slave D-type latch synchronized with the inverse of the clock signal,
a NOR gate for producing an output signal expressing the negated logic sum of a Q-terminal output from a master D-type latch of a final stage of said cascade-connected plurality of master-slave D-type flip-flops and a Q-terminal output from a slave D-type latch of said final stage,
means for applying said NOR gate output signal to a D input terminal of a master D-type latch of a master-slave D-type flip-flop of an initial stage of said cascade-connected plurality of master-slave D-type flip-flops, and
means for outputting said NOR gate output signal as a final output signal of said frequency divider.

2. A 90° phase splitter circuit comprising
a master-slave D-type flip-flop which operates from a clock signal constituted by a final output signal produced by an odd number factor frequency divider as claimed in claim 1,
means for connecting an inverting Q-terminal output from a slave D-type latch of said master-slave D-type flip-flop to a D input terminal of a master D-type latch thereof, and
means for outputting respective Q-terminal output signals from said master D-type latch and slave D-type latch, as final output signals of said 90° phase splitter circuit.

3. A frequency divider method comprising:
performing frequency division operation by supplying an externally derived signal, as a clock signal, to a circuit formed of a plurality of master-slave D-type flip-flops connected in cascade and each synchronized with the clock signal, each master-slave D-type flip-flop being formed of a master D-type latch and a slave D-type latch connected in cascade, with the master D-type latch synchronized with the clock signal and the slave D-type latch synchronized with the inverse of the clock signal,
deriving a negated logic sum signal by inputting to a NOR gate a Q-terminal output from a master D-type latch of a final stage of said cascade-connected plurality of master-slave D-type flip-flops and a Q-terminal output from a slave D-type latch of said final stage, and
applying said negated logic sum signal to a D input terminal of a master D-type latch of a master-slave D-type flip-flop of an initial stage of said cascade-connected plurality of master-slave D-type flip-flops, while outputting said negated logic sum signal as a final output signal.

4. A mobile radio apparatus incorporating a 90° phase splitter as claimed in claim 2.
